# EUROPEAN PATENT APPLICATION

(11) **EP 4 610 680 A1**
(43) Date of publication of application: **03.09.2025**
(21) Application number: 23889167.5
(22) Date of filing: 09.11.2023
(51) Int. Cl.: G01R 31/392, G01R 31/3842, G01R 31/396, G01R 19/00, G01R 19/165, G01R 31/371, G01R 31/56, G08B 21/18, H01M 10/48

(54) **BATTERY ABNORMALITY DIAGNOSIS DEVICE, AND OPERATION METHOD THEREFOR**

(30) Priority: 11.11.2022 KR 20220151061
(71) Applicant: LG Energy Solution, Ltd., Seoul 07335 (KR)
(72) Inventor: YOON, Sung Yul, Daejeon 34122 (KR); KIM, In Sik, Daejeon 34122 (KR); LEE, Jeong Bin, Daejeon 34122 (KR); KIM, Soon Jong, Daejeon 34122 (KR); KIM, Won Kyung, Daejeon 34122 (KR); KWON, Ki Wook, Daejeon 34122 (KR); SONG, Young Seok, Daejeon 34122 (KR)
(74) Representative: Plasseraud IP
(86) International application number: PCT/KR2023/017955
(87) International publication number: WO 2024/101909

(57) **Abstract**

A battery abnormality diagnosis apparatus according to an embodiment disclosed herein includes an obtaining unit configured to obtain voltage-state-of-charge (SOC) profiles of a plurality of battery units, an identifying unit configured to identify a designated first number of ranks of each of the plurality of battery units, based on the voltage-SOC profiles, and a diagnosing unit configured to diagnose abnormality of the plurality of battery units, based on changes of the ranks.

## Description

### [TECHNICAL FIELD]

### CROSS-REFERENCE TO RELATED APPLICATION

This application claims priority to and the benefit of Korean Patent Application No. 10-2022-0151061 filed in the Korean Intellectual Property Office on November 11, 2022, the entire content of which is incorporated herein by reference.

### TECHNICAL FIELD

Embodiments disclosed herein relate to a battery abnormality diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium ion battery is attracting attention as a next-generation energy storage medium as a usage range thereof is expanded to a power source of electric vehicles.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device. The battery management system may also manage and control the battery in a state of being spaced apart from a device including the battery.

### [DISCLOSURE]

### [TECHNICAL PROBLEM]

When a short circuit or a failure of another type occurs inside a battery, the possibility of damage to devices (e.g., EV, ESS) including the battery may increase.

Accordingly, there is a need for a scheme to reduce the possibility of damage to devices including a battery by detecting an abnormal state of the battery.

Technical problems of the embodiments disclosed herein are not limited to the above-described technical problems, and other unmentioned technical problems would be clearly understood by one of ordinary skill in the art from the following description.

### [TECHNICAL SOLUTION]

A battery abnormality diagnosis apparatus according to an embodiment disclosed herein includes an obtaining unit configured to obtain voltage-state-of-charge (SOC) profiles of a plurality of battery units, an identifying unit configured to identify a designated first number of ranks of each of the plurality of battery units, based on the voltage-SOC profiles, and a diagnosing unit configured to diagnose abnormality of the plurality of battery units, based on changes of the ranks.

In an embodiment, the identifying unit may be further configured to identify representative voltage values of the SOC periods of the first number of each of the voltage-SOC profiles and identify the ranks based on the representative voltage values.

In an embodiment, the identifying unit may be further configured to identify an average value of the voltage values of each of the SOC periods of the first number, as a representative voltage value.

In an embodiment, the diagnosing unit may be further configured to diagnose, as an abnormal battery unit, at least one battery unit having the ranks changing by a reference value or greater among the plurality of battery units.

In an embodiment, the reference value may be set based on a number of the plurality of battery units.

In an embodiment, the diagnosing unit may be further configured to diagnose, as the abnormal battery unit, at least one battery unit having the ranks increasing by the reference value or greater or decreasing by the reference value or greater among the plurality of battery units.

In an embodiment, the obtaining unit may be further configured to obtain the voltage-SOC profiles of the plurality of battery units through an external electronic device connected through a wired and/or wireless network.

In an embodiment, the obtaining unit may be further configured to read a voltage, a current, a temperature, or a combination thereof from each of the plurality of battery units and generate the voltage-SOC profiles based on the read voltage, current, temperature, or combination thereof.

In an embodiment, the plurality of battery units may include one of a battery cell, a battery module, a battery pack, or a battery rack.

In an embodiment, the battery abnormality diagnosis apparatus may further include an abnormality processing unit configured to perform an abnormality processing function based on an abnormality diagnosis result of the plurality of battery units, in which the abnormality processing function includes a notification function or a shortcircuit function.

An operating method of a battery abnormality diagnosis apparatus according to an embodiment disclosed herein includes obtaining voltage-state-of-charge (SOC) profiles of a plurality of battery units, identifying a designated first number of ranks of each of the plurality of battery units, based on the voltage-SOC profiles, and diagnosing abnormality of the plurality of battery units, based on changes of the ranks.

In an embodiment, the identifying may include identifying representative voltage values of the SOC periods of the first number of each of the voltage-SOC profiles and identifying the ranks based on the representative voltage values.

In an embodiment, the identifying may include identifying an average value of the voltage values of each of the SOC periods of the first number, as a representative voltage value.

In an embodiment, the diagnosing may include diagnosing, as an abnormal battery unit, at least one battery unit having the ranks changing by a reference value or greater among the plurality of battery units.

In an embodiment, the reference value may be set based on a number of the plurality of battery units.

In an embodiment, the diagnosing may include diagnosing, as the abnormal battery unit, at least one battery unit having the ranks increasing by the reference value or greater or decreasing by the reference value or greater among the plurality of battery units.

In an embodiment, the obtaining may include obtaining the voltage-SOC profiles of the plurality of battery units through an external electronic device connected through a wired and/or wireless network.

In an embodiment, the obtaining may include reading a voltage, a current, a temperature, or a combination thereof from each of the plurality of battery units and generating the voltage-SOC profiles based on the read voltage, current, temperature, or combination thereof.

In an embodiment, the plurality of battery units may include one of a battery cell, a battery module, a battery pack, or a battery rack.

In an embodiment, the operating method may further include performing an abnormality processing function based on an abnormality diagnosis result of the plurality of battery units, in which the abnormality processing function includes a notification function or a shortcircuit function.

### [ADVANTAGEOUS EFFECTS]

A battery abnormality diagnosis apparatus and an operating method thereof according to various embodiments disclosed herein may detect occurrence of a short circuit or a failure of another type inside a battery.

A battery abnormality diagnosis apparatus and an operating method thereof according to various embodiments disclosed herein may process the detected short circuit or failure of another type inside the battery.

The effects of the battery abnormality diagnosis apparatus and the operating method thereof according to the disclosure of the present document are not limited to the effects mentioned above, and other effects not mentioned will be clearly understood by those of ordinary skill in the art according to the disclosure of the present document.

### [DESCRIPTION OF DRAWINGS]

FIG. 1 show graphs of voltage-state-of-charge (SOC) profiles.
FIG. 2 illustrates a battery abnormality diagnosis apparatus according to an embodiment of the present disclosure.
FIG. 3 illustrates a voltage-SOC profile.
FIG. 4 illustrates a graph of an average voltage of battery units.
FIG. 5 illustrates a graph of a rank change of battery units.
FIG. 6 is a flowchart showing an operating method of a battery abnormality diagnosis apparatus according to an embodiment of the present disclosure.
FIG. 7 is a flowchart showing an operating method of a battery abnormality diagnosis apparatus according to an embodiment of the present disclosure.

With regard to the description of the drawings, similar reference numerals may be used to refer to similar or related components.

### [MODE FOR INVENTION]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

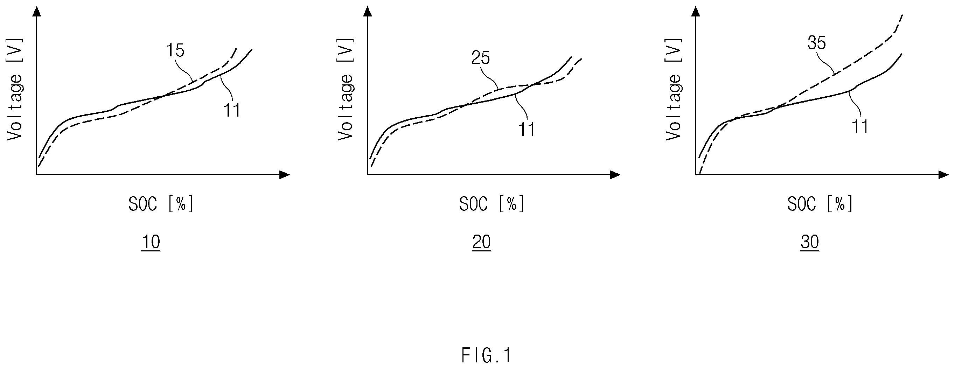

FIG. 1 show graphs of voltage-state-of-charge (SOC) profiles. Referring to FIG. 1, a voltage-SOC profile graph 10 showing a normal behavior 11 and a deterioration behavior 15 of a battery unit, a voltage-SOC profile graph 20 showing the normal behavior 11 and an abnormal behavior 25 of a battery unit, and a voltage-SOC profile graph 30 showing the normal behavior 11 and an abnormal behavior 35 of the battery unit may be seen. Damage to an electronic device may occur due to the battery unit showing the abnormal behavior. Thus, a battery unit having an abnormal behavior may be detected from among battery units, and may need to be appropriately processed.

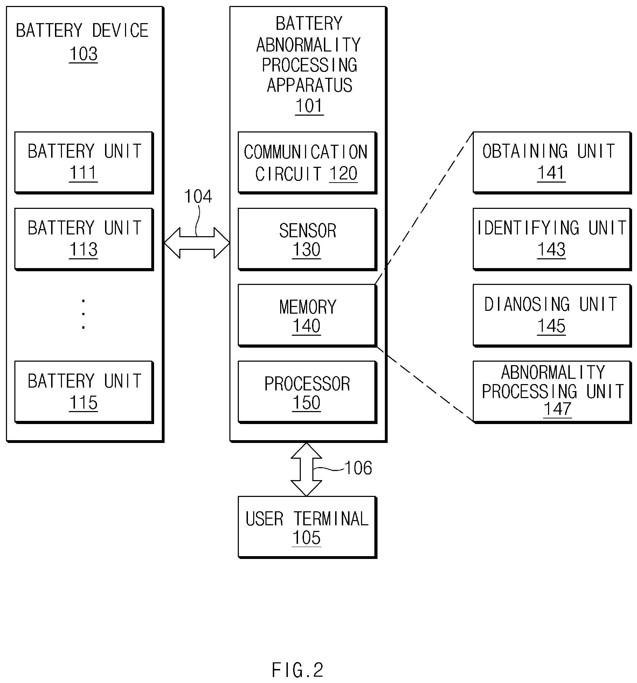

FIG. 2 is a block diagram of a battery abnormality diagnosis apparatus 101 according to an embodiment of the present disclosure.

Referring to FIG. 2, the battery abnormality diagnosis apparatus 101 may be wiredly and/or wirelessly connected to an electronic device 103 and a user terminal 105.

In an embodiment, connection 104 between the battery abnormality diagnosis apparatus 101 and the electronic device 103 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4^{th}-Generation (4G) network, a 5^{th}-Generation (5G) network).

In another embodiment, the connection 104 between the battery abnormality diagnosis apparatus 101 and the electronic device 103 may be connection using a device-to-device communication scheme (e.g., a bus, a general-purpose input and output (GPIO), a serial peripheral interface (SPI), or a mobile industry processor interface (MIPI)).

In an embodiment, connection 106 between the battery abnormality diagnosis apparatus 101 and the user terminal 105 may be communication connection through a wired and/or wireless network.

In an embodiment, the electronic device 103 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

In an embodiment, the electronic device 103 may include one or more battery units 111, 113, and 115. Each of the one or more battery units 111, 113, and 115 may be a battery cell, a battery module, a battery pack, or a battery rack.

In an embodiment, the user terminal 105 may be a mobile device (e.g., a mobile phone, a laptop computer, a smart phone, a smart pad), or a personal computer (PC).

In an embodiment, the battery abnormality diagnosis apparatus 101 may include a communication circuit 120, a sensor 130, a memory 140, and a processor 150. According to an embodiment, the battery abnormality diagnosis apparatus 101 shown in FIG. 2 may further include at least one component (e.g., a display, an input device, or an output device) in addition to components shown in FIG. 2.

In an embodiment, the communication circuit 120 may establish a wired communication channel and/or a wireless communication channel between the battery abnormality diagnosis apparatus 101 and the electronic device 103 and/or the user terminal 105, and transmit and receive data to and from the electronic device 103 and/or the user terminal 105 through the established communication channel.

In an embodiment, the sensor 130 may obtain values related to states of the battery units 111, 113, and 115 of the electronic device 103. In an embodiment, the values related to the states may indicate one or more values of voltages, currents, resistances, SOC, states of health (SOH), or temperatures of the battery units 111, 113, and 115 or combinations thereof. Hereinbelow, the value related to the state may be referred to as a 'state value'.

In an embodiment, the memory 140 may include a volatile and/or a nonvolatile memory.

In an embodiment, the memory 140 may store data used by at least one component (e.g., the processor 150) of the battery state estimation apparatus 100. For example, the data may include software (or an instruction related thereto), input data, or output data. In an embodiment, the instruction, when executed by the processor 150, may cause the battery abnormality diagnosis apparatus 101 to perform operations defined by the instruction.

In an embodiment, the memory 140 may include one or more software (e.g., an obtaining unit 141, an identifying unit 143, a diagnosing unit 145, and an abnormality processing unit 147).

In an embodiment, the processor 150 may include a central processing unit, an application processor, a graphic processing unit, a neural processing unit (NPU), an image signal processor, a sensor hub processor, or a communication processor.

In an embodiment, the processor 150 may execute software (e.g., the obtaining unit 141, the identifying unit 143, the diagnosing unit 145, and the abnormality processing unit 147) to control at least one other component (e.g., a hardware or software component) of the battery diagnosis apparatus 101 connected to the processor 150 and perform various data processing or operations.

Hereinbelow, referring to FIGS. 2 to 5, a description will be made of a method, performed by the battery abnormality diagnosis apparatus 101, of diagnosing abnormality of the battery units 111, 113, and 115 through the obtaining unit 141, the identifying unit 143, the diagnosing unit 145, and/or the abnormality processing unit 147.

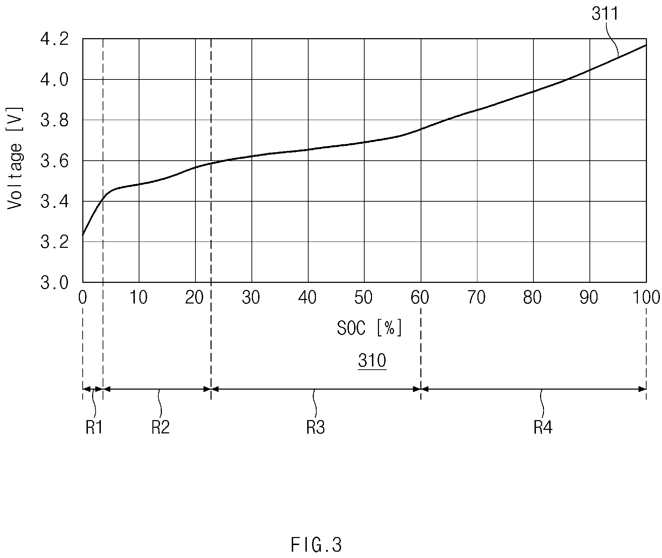

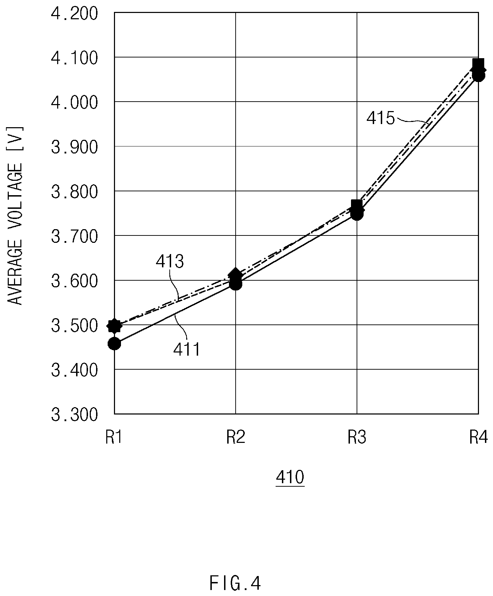

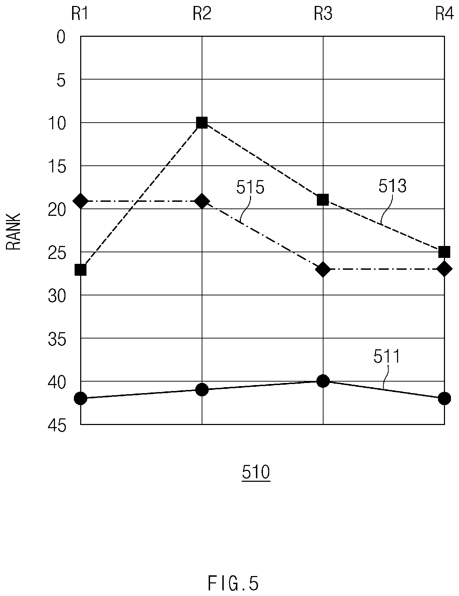

FIG. 3 is a view 310 showing a voltage-SOC profile 311. FIG. 4 is a graph 410 showing an average voltage of battery units. FIG. 5 is a graph 510 showing a rank change of battery units. FIGS. 3 to 5 may be described with reference to FIG. 2.

In an embodiment, the obtaining unit 141 may obtain voltage-SOC profiles of the plurality of battery units 111, 113, and 115. In an embodiment, the voltage-SOC profile may indicate a relationship between an SOC of a battery unit (e.g., the battery unit 111) and a voltage.

In an embodiment, the obtaining unit 141 may obtain the voltage-SOC profiles of the plurality of respective battery unit 111, 113, and 115 through the electronic device 103 connected through a wired and/or wireless network. In another embodiment, the obtaining unit 141 may obtain voltages, currents, temperatures of the plurality of battery unit 111, 113, and 115, or a combination thereof through the electronic device 103 connected through a wired and/or wireless network, and generate the voltage-SOC profiles based on the obtained voltages, currents, temperatures, or combination thereof.

In an embodiment, the obtaining unit 141 may read the voltage, current, temperature, or a combination thereof, from each of the plurality of battery unit 111, 113, and 115, and generate the voltage-SOC profiles based on the read voltage, current, temperature, or combination thereof.

In an embodiment, the identifying unit 143 may identify a designated first number of ranks of each of the plurality of battery units 111, 113, and 115, based on the voltage-SOC profiles. Herein, the designated first number may correspond to the number of SOC periods. Herein, the SOC periods may include periods for identifying an SOC during charging of the battery unit from 0 % to 100 %, and/or periods for identifying an SOC during discharging of the battery unit from 100 % to 0 %.

For example, referring to FIG. 3, the designated first number may be 4 that is the number of SOC periods R1, R2, R3, and R4 in which the battery unit is being charged. In an embodiment, an SOC period R1 may be a period in which an SOC is between 0 % and 5 %, an SOC period R2 may be a period in which an SOC is between 5 % and 25 %, an SOC period R3 is a period may be which an SOC is between 25 % and 60 %, and an SOC period R4 may be a period in which an SOC is between 60 % and 100 %. Additionally, the designated first number may be 8 including the SOC periods R1, R2, R3, and R4 in which the battery unit is being charged and SOC periods R5, R6, R7, and R8 in which the battery unit is being discharged. In an embodiment, the SOC period R5 may be a period in which an SOC is between 100 % and 60 %, the SOC period R6 may be a period in which an SOC is between 60 % and 25 %, the SOC period R7 is a period may be which an SOC is between 25 % and 5 %, and the SOC period R8 may be a period in which an SOC is between 5 % and 0 %.

In an embodiment, the identifying unit 143 may identify ranks of the plurality of battery units 111, 113, and 115 in each of the SOC periods. For example, the identifying unit 143 may identify ranks of the plurality of battery units 111, 113, and 115 in the SOC period R1, ranks of the plurality of battery units 111, 113, and 115 in the SOC period R2, ranks of the plurality of battery units 111, 113, and 115 in the SOC period R3, and ranks of the plurality of battery units 111, 113, and 115 in the SOC period R4.

In an embodiment, the identifying unit 143 may identify representative voltage values of the SOC periods of the first number of each of the voltage-SOC profiles and identify the ranks based on the representative voltage values. Herein, the representative voltage value may be an average value of voltage values of each of the SOC periods of the first number. Thus, the identifying unit 143 may identify the average value of the voltage values of each of the SOC periods of the first number as a representative voltage value.

For example, the identifying unit 143 may identify the average value of the voltage values of each of the SOC periods of the first number as a representative voltage value, as shown in Table 1.

**[Table 1]**

| Battery Unit | Charging | | | | Discharging | | | |
|---|---|---|---|---|---|---|---|---|
| | R1 | R2 | R3 | R4 | R5 | R6 | R7 | R8 |
| 111 | 3.458 | 3.597 | 3.754 | 4.064 | 3.847 | 3.579 | 3.417 | 3.385 |
| 113 | 3.492 | 3.605 | 3.760 | 4.074 | 3.858 | 3.588 | 3.443 | 3.431 |
| ... | ... | ... | ... | ... | ... | ... | ... | ... |
| 115 | 3.495 | 3.604 | 3.758 | 4.074 | 3.857 | 3.587 | 3.444 | 3.436 |

Referring to Table 1, the representative voltage values in the SOC periods R1, R2, R3, and R4 during charging of the battery unit 111 may be 3.458, 3.597, 3.754, and 4.064. During discharging of the battery unit 111, the representative voltage values in the SOC periods R5, R6, R7, and R8 may be 3.847, 3.579, 3.417, and 3.385. Referring to FIG. 4, representative voltage values in the SOC periods R1, R2, R3, and R4 of each of the battery units 111, 113, and 115 are shown. For example, the representative voltage values of the battery unit 111 may be identified from a line 411, the representative voltage values of the battery unit 113 may be identified from a line 413, and the representative voltage values of the battery unit 115 may be identified from a line 415.

For example, the identifying unit 143 may identify the ranks as shown in Table 2, based on the representative voltage values shown in Table 1.

**[Table 2]**

| Battery Unit | Charging | | | | Discharging | | | |
|---|---|---|---|---|---|---|---|---|
| | R1 | R2 | R3 | R4 | R5 | R6 | R7 | R8 |
| 111 | 42 | 41 | 40 | 42 | 42 | 42 | 42 | 42 |
| 113 | 27 | 10 | 19 | 25 | 23 | 19 | 16 | 23 |
| ... | ... | ... | ... | ... | ... | ... | ... | ... |
| 115 | 19 | 19 | 27 | 27 | 25 | 13 | 12 | 20 |

Referring to Table 2, the ranks in the SOC periods R1, R2, R3, and R4 during charging of the battery unit 111 may be 42, 41, 40, and 42. During discharging of the battery unit 111, the representative voltage values in the SOC periods R5, R6, R7, and R8 may be 42, 42, 42, and 42. Referring to FIG. 5, ranks in the SOC periods R1, R2, R3, and R4 of each of the battery units 111, 113, and 115 are shown. For example, the ranks of the battery unit 111 may be identified from a line 511, the ranks of the battery 113 may be identified from a line 513, and the ranks of the battery unit 115 may be identified from a line 515.

In an embodiment, the diagnosing unit 145 may diagnose abnormality of the plurality of battery units 111, 113, and 115 based on rank changes.

For example, the identifying unit 143 may identify the rank changes as shown in Table 3, based on the ranks shown in Table 2.

**[Table 3]**

| Battery Unit | Charging | | | Discharging | | |
|---|---|---|---|---|---|---|
| | R1-R2 | R2-R3 | R3-R4 | R5-R6 | R6-R7 | R7-R8 |
| 111 | 1 | 1 | -2 | 0 | 0 | 0 |
| 113 | 17 | -9 | -6 | 14 | -7 | -7 |
| ... | ... | ... | ... | ... | ... | ... |
| 115 | 0 | 8 | 0 | -12 | -1 | 8 |

Referring to Table 3, the rank changes among the SOC periods R1, R2, R3, and R4 during charging of the battery unit 111 may be 1, 1, and -2. During discharging of the battery unit 111, the rank changes among the SOC periods R5, R6, R7, and R8 may be 0, 0, 0, and 0. As shown in Table 3, the diagnosing unit 145 may identify rank changes among the SOC periods R1, R2, R3, and R4 during charging and identify rank changes among the SOC periods R5, R6, R7, and R8 during discharging.

In an embodiment, the diagnosing unit 145 may diagnose, among the plurality of battery units 111, 113, and 115, a battery unit having a rank changing by a reference value or greater, as an abnormal battery unit. The reference value may be set based on the number of plurality of battery units. For example, a value corresponding to 1/3 of the number of battery units 111, 113, and 115 may be set to the reference value. For example, when the number of battery units 111, 113, and 115 is 42, the reference value may be 14.

In an embodiment, the diagnosing unit 145 may diagnose, among the plurality of battery units 111, 113, and 115, a battery unit having a rank increasing by the reference value or greater or decreasing by the reference value or greater, as the abnormal battery unit.

For example, when the reference value is 8, the battery unit 113 of Table 3 has a rank increase of 17 between the rank of the SOC period R1 and the rank of the SOC period R2 and a rank decrease of 9 between the rank of the SOC period R2 and the rank of the SOC period R3, such that the diagnosing unit 145 may diagnose the battery unit 113 as the abnormal battery unit.

In an embodiment, the abnormality processing unit 147 may perform an abnormality processing function based on abnormality diagnosis results for the plurality of battery units 111, 113, and 115. In an embodiment, the abnormality processing function may include a notification function or a shortcircuit function.

For example, the abnormality processing unit 147 may transmit the abnormality diagnosis results of the plurality of battery units 111, 113, and 115 to the user terminal 105 connected through a wired and/or wireless network.

In another embodiment, the abnormality processing unit 147 may isolate the abnormality battery unit from the electronic device 103 based on the abnormality diagnosis results of the plurality of battery units 111, 113, and 115. Herein, isolation may include electrical and/or mechanical isolation.

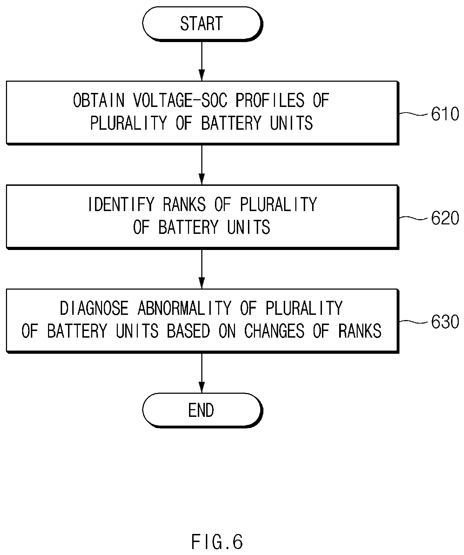

FIG. 6 is a flowchart showing an operating method of the battery abnormality diagnosis apparatus 101 according to an embodiment of the present disclosure.

Referring to FIG. 6, in operation 610, the battery abnormality diagnosis apparatus 101 may obtain voltage-SOC profiles of the plurality of battery units 111, 113, and 115. In an embodiment, the voltage-SOC profile may indicate a relationship between an SOC of a battery unit (e.g., the battery unit 111) and a voltage.

In an embodiment, the battery abnormality diagnosis apparatus 101 may obtain the voltage-SOC profiles of the plurality of respective battery unit 111, 113, and 115 through the electronic device 103 connected through a wired and/or wireless network. In another embodiment, the battery abnormality diagnosis apparatus 101 may obtain voltages, currents, temperatures of the plurality of battery unit 111, 113, and 115, or a combination thereof through the electronic device 103 connected through a wired and/or wireless network, and generate the voltage-SOC profiles based on the obtained voltages, currents, temperatures, or combination thereof.

In an embodiment, the battery abnormality diagnosis apparatus 101 may read the voltage, current, temperature, or a combination thereof, from each of the plurality of battery unit 111, 113, and 115, and generate the voltage-SOC profiles based on the read voltage, current, temperature, or combination thereof.

In operation 620, the battery abnormality diagnosis apparatus 101 may identify the ranks of the plurality of battery units 111, 113, and 115. In an embodiment, the battery abnormality diagnosis apparatus 101 may identify the designated first number of ranks of each of the plurality of battery units 111, 113, and 115, based on the voltage-SOC profiles. Herein, the designated first number may correspond to the number of SOC periods. Herein, the SOC periods may include periods for identifying an SOC during charging of the battery unit from 0 % to 100 %, and/or periods for identifying an SOC during discharging of the battery unit from 100 % to 0 %.

In an embodiment, the battery abnormality diagnosis apparatus 101 may identify representative voltage values of the SOC periods of the first number of each of the voltage-SOC profiles and identify the ranks based on the representative voltage values. Herein, the representative voltage value may be an average value of voltage values of each of the SOC periods of the first number.

In operation 630, the battery abnormality diagnosis apparatus 101 may diagnose the abnormality of the plurality of battery units 111, 113, and 115, based on the rank changes.

In an embodiment, the battery abnormality diagnosis apparatus 101 may diagnose, among the plurality of battery units 111, 113, and 115, a battery unit having a rank changing by a reference value or greater, as an abnormal battery unit. The reference value may be set based on the number of plurality of battery units. For example, a value corresponding to 1/3 of the number of battery units 111, 113, and 115 may be set to the reference value. For example, when the number of battery units 111, 113, and 115 is 42, the reference value may be 14.

In an embodiment, the battery abnormality diagnosis apparatus 101 may diagnose, among the plurality of battery units 111, 113, and 115, a battery unit having a rank increasing by the reference value or greater or decreasing by the reference value or greater, as the abnormal battery unit.

In an embodiment, the battery abnormality diagnosis apparatus101 may perform an abnormality processing function based on abnormality diagnosis results for the plurality of battery units 111, 113, and 115. In an embodiment, the abnormality processing function may include a notification function or a shortcircuit function.

For example, the battery abnormality diagnosis apparatus 101 may transmit the abnormality diagnosis results of the plurality of battery units 111, 113, and 115 to the user terminal 105 connected through a wired and/or wireless network.

In another embodiment, the battery abnormality diagnosis apparatus 101 may isolate the abnormality battery unit from the electronic device 103 based on the abnormality diagnosis results of the plurality of battery units 111, 113, and 115. Herein, isolation may include electrical and/or mechanical isolation.

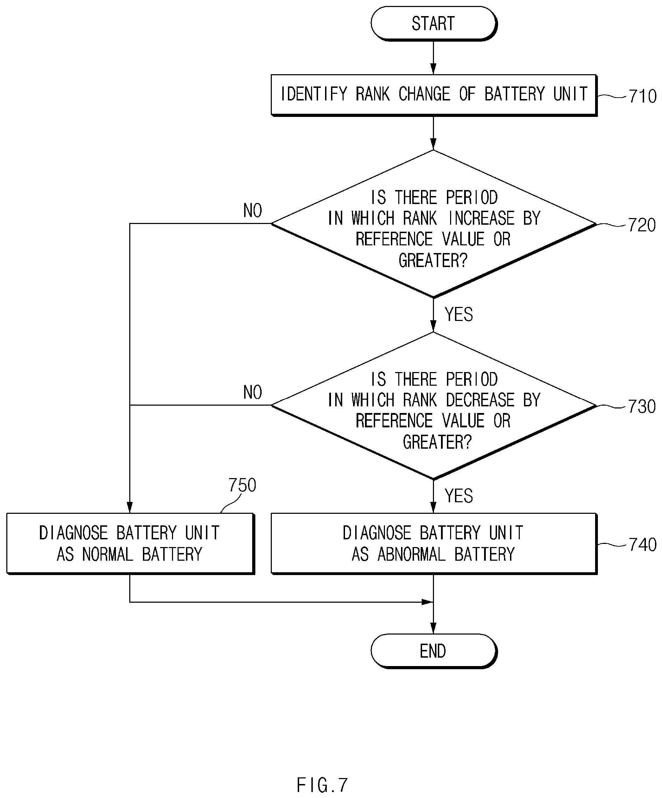

FIG. 7 is a flowchart showing an operating method of the battery abnormality diagnosis apparatus 101 according to an embodiment of the present disclosure. Operations of FIG. 7 may be performed for each of the battery units 111, 113, and 115. Operations of FIG. 7 may be included in operation 630 of FIG. 6.

Referring to FIG. 7, in operation 710, the battery abnormality diagnosis apparatus 101 may identify a rank change of a battery unit.

In operation 720, the battery abnormality diagnosis apparatus 101 may determine whether there is a period in which the rank increases by the reference value or greater. The reference value may be set based on the number of plurality of battery units. For example, a value corresponding to 1/3 of the number of battery units 111, 113, and 115 may be set to the reference value. For example, when the number of battery units 111, 113, and 115 is 42, the reference value may be 14.

As a determination result in operation 720, when there is a period in which the rank increases by the reference value or greater (Yes), the battery abnormality diagnosis apparatus 101 may perform operation 730. As a determination result in operation 720, when there is no period in which the rank increases by the reference value or greater (No), the battery abnormality diagnosis apparatus 101 may perform operation 750.

In operation 730, the battery abnormality diagnosis apparatus 101 may determine whether there is a period in which the rank decreases by the reference value or greater. Herein, the reference value may be identical to the reference value in operation 720.

As a determination result in operation 730, when there is a period in which the rank decreases by the reference value or greater (Yes), the battery abnormality diagnosis apparatus 101 may perform operation 740. As a determination result in operation 730, when there is no period in which the rank decreases by the reference value or greater (No), the battery abnormality diagnosis apparatus 101 may perform operation 750.

In operation 740, the battery abnormality diagnosis apparatus 101 may diagnose the battery unit as an abnormal battery.

In operation 750, the battery abnormality diagnosis apparatus 101 may diagnose the battery unit as a normal battery.

According to an embodiment, operation 720 and 730 may be performed at the same time. According to an embodiment, operation 720 may performed after operation 730.

## Claims

1. A battery abnormality diagnosis apparatus comprising:
an obtaining unit configured to obtain voltage-state-of-charge (SOC) profiles of a plurality of battery units;
an identifying unit configured to identify a designated first number of ranks of each of the plurality of battery units, based on the voltage-SOC profiles; and
a diagnosing unit configured to diagnose abnormality of the plurality of battery units, based on changes of the ranks.

2. The battery abnormality diagnosis apparatus of claim 1, wherein the identifying unit is further configured to:
identify representative voltage values of the SOC periods of the first number of each of the voltage-SOC profiles; and
identify the ranks based on the representative voltage values.

3. The battery abnormality diagnosis apparatus of claim 2, wherein the identifying unit is further configured to identify an average value of the voltage values of each of the SOC periods of the first number, as a representative voltage value.

4. The battery abnormality diagnosis apparatus of claim 1, wherein the diagnosing unit is further configured to diagnose, as an abnormal battery unit, at least one battery unit having the ranks changing by a reference value or greater among the plurality of battery units.

5. The battery abnormality diagnosis apparatus of claim 4, wherein the reference value is set based on a number of the plurality of battery units.

6. The battery abnormality diagnosis apparatus of claim 4, wherein the diagnosing unit is further configured to diagnose, as the abnormal battery unit, at least one battery unit having the ranks increasing by the reference value or greater or decreasing by the reference value or greater among the plurality of battery units.

7. The battery abnormality diagnosis apparatus of claim 1, wherein the obtaining unit is further configured to obtain the voltage-SOC profiles of the plurality of battery units through an external electronic device connected through a wired and/or wireless network.

8. The battery abnormality diagnosis apparatus of claim 1, wherein the obtaining unit is further configured to:
read a voltage, a current, a temperature, or a combination thereof from each of the plurality of battery units; and
generate the voltage-SOC profiles based on the read voltage, current, temperature, or combination thereof.

9. The battery abnormality diagnosis apparatus of claim 1, wherein the plurality of battery units comprise one of a battery cell, a battery module, a battery pack, or a battery rack.

10. The battery abnormality diagnosis apparatus of claim 1, further comprising an abnormality processing unit configured to perform an abnormality processing function based on an abnormality diagnosis result of the plurality of battery units,
wherein the abnormality processing function comprises a notification function or a shortcircuit function.

11. An operating method of a battery abnormality diagnosis apparatus, the operating method comprising:
obtaining voltage-state-of-charge (SOC) profiles of a plurality of battery units;
identifying a designated first number of ranks of each of the plurality of battery units, based on the voltage-SOC profiles; and
diagnosing abnormality of the plurality of battery units, based on changes of the ranks.

12. The operating method of claim 11, wherein the identifying comprises:
identifying representative voltage values of the SOC periods of the first number of each of the voltage-SOC profiles; and
identifying the ranks based on the representative voltage values.

13. The operating method of claim 12, wherein the identifying comprises identifying an average value of the voltage values of each of the SOC periods of the first number, as a representative voltage value.

14. The operating method of claim 11, wherein the diagnosing comprises diagnosing, as an abnormal battery unit, at least one battery unit having the ranks changing by a reference value or greater among the plurality of battery units.

15. The operating method of claim 14, wherein the reference value is set based on a number of the plurality of battery units.

16. The operating method of claim 14, wherein the diagnosing comprises diagnosing, as the abnormal battery unit, at least one battery unit having the ranks increasing by the reference value or greater or decreasing by the reference value or greater among the plurality of battery units.

17. The operating method of claim 11, wherein the obtaining comprises obtaining the voltage-SOC profiles of the plurality of battery units through an external electronic device connected through a wired and/or wireless network.

18. The operating method of claim 11, wherein the obtaining comprises:
reading a voltage, a current, a temperature, or a combination thereof from each of the plurality of battery units; and
generating the voltage-SOC profiles based on the read voltage, current, temperature, or combination thereof.

19. The operating method of claim 11, wherein the plurality of battery units comprise one of a battery cell, a battery module, a battery pack, or a battery rack.

20. The operating method of claim 11, further comprising performing an abnormality processing function based on an abnormality diagnosis result of the plurality of battery units,
wherein the abnormality processing function comprises a notification function or a shortcircuit function.
